# FASCICULE DE BREVET EUROPEEN

(11) **EP 2 246 931 B1**
(45) Date de publication et mention de la délivrance du brevet: **19.09.2012**
(21) Numéro de dépôt: 10156964.8
(22) Date de dépôt: 18.03.2010
(51) Int. Cl.: H01P 1/20

(54) **Filtre de mode commun à inductances couplées**
Gleichtaktfilter mit gekoppelten Drosselspulen
Common-mode filter with coupled inductors

(30) Priorité: 30.04.2009 FR 0952872
(43) Date de publication de la demande: 03.11.2010
(73) Titulaire: STMicroelectronics (Tours) SAS, 37100 Tours (FR)
(72) Inventeur: Concord, Joël, 37100 Tours (FR)
(74) Mandataire: de Beaumont, Michel

(56) Documents cités:
- JP-A- 2 270 414
- US-A1- 2007 035 974
- US-A1- 2007 188 265
- US-B1- 6 529 750

## Description

### Domaine de l'invention

La présente invention concerne de façon générale les circuits électroniques et, plus particulièrement, les filtres de mode commun utilisés dans de tels circuits.

### Exposé de l'art antérieur

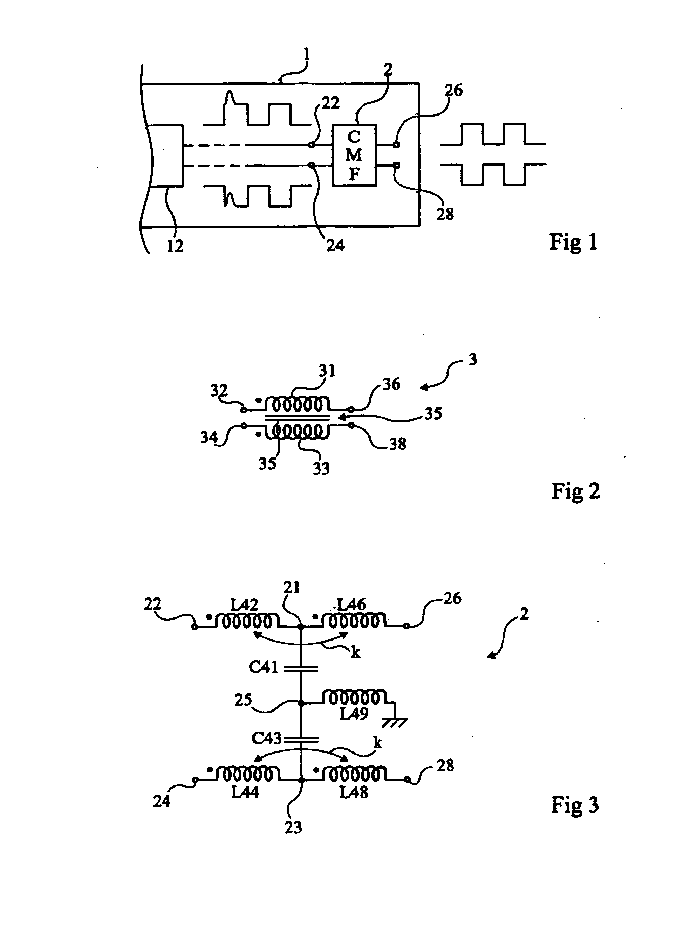

La figure 1 est un schéma bloc d'une carte électronique 1 comportant, outre un ou plusieurs circuits 12 susceptibles de fournir des signaux différentiels, au moins un filtre de mode commun 2 (CMF) du type auquel s'applique la présente invention. Un tel filtre comporte deux bornes d'entrée 22 et 24 et deux bornes de sortie 26 et 28. Les bornes d'entrée sont destinées à recevoir les signaux différentiels à traiter dont le résultat filtré est fourni en sortie.

Comme l'illustrent des exemples d'allures de signaux en figure 1, le rôle d'un filtre de mode commun est de laisser passer les signaux différentiels qui sont en opposition de phase et d'atténuer ou couper les signaux ou perturbations de mode commun qui sont en phase sur les deux entrées. Un filtre de mode commun idéal est un court-circuit pour les signaux en opposition de phase et un circuit ouvert pour les signaux en phase. En pratique, le filtre laisse toujours passer les basses fréquences, donc un niveau de polarisation commun aux deux signaux différentiels.

Des filtres de mode commun sont généralement utilisés pour des accès de données différentiels dans des circuits de traitement numérique, notamment si la fréquence des signaux utiles est dans la même bande que la fréquence des signaux ou des perturbations de mode commun que l'on cherche à rejeter.

On trouve également des filtres de mode commun dans des circuits analogiques, par exemple, pour traiter des signaux dans des microphones différentiels dont le signal est transmis de façon symétrique.

La figure 2 représente un exemple de filtre de mode commun 3 usuel. Un tel filtre est constitué de deux inductances 31 et 33 reliant respectivement des accès 32 d'entrée et 36 de sortie, et des accès 34 d'entrée et 38 de sortie. Les inductances 31 et 33 sont couplées par un matériau magnétique 35. Les points de phase respectifs des inductances 31 et 33 sont du même côté (dans l'exemple, côté des bornes d'entrée 32 et 34) afin de ne pas filtrer les signaux en opposition de phase. Le principe de fonctionnement du filtre 3 de la figure 2 est de présenter une impédance série élevée pour des signaux en phase et une impédance série faible pour des signaux en opposition de phase.

Le recours à un matériau magnétique 35 est lié au besoin d'avoir des inductances de forte valeur susceptibles de présenter une impédance série élevée en mode commun, sans que la taille du filtre ne devienne trop importante.

Cette solution est donc limitée aux applications dans lesquelles on peut utiliser un tel matériau magnétique. Ce n'est en particulier pas le cas pour intégrer les filtres de mode commun par exemple sur des substrats semiconducteurs ou isolants (par exemple en verre). Intégrer des éléments inductifs avec le dépôt d'une couche ferromagnétique est non seulement difficile mais en plus très coûteux.

Il existe donc un besoin pour un filtre de mode commun dépourvu de matériau magnétique.

Par ailleurs, en technologie intégrée, on a souvent besoin de protéger les circuits contre d'éventuels décharges électrostatiques. Il existe donc également un besoin de réaliser un filtre de mode commun avec protection ESD.

Le document US 2007/0188265 décrit un circuit fournissant une compensation d'inductance parasite de plusieurs condensateurs.

### Résumé

La présente invention vise à pallier tout ou partie des inconvénients des filtres de mode commun usuels.

Un mode de réalisation de la présente invention vise plus particulièrement à éviter le recours à un matériau magnétique dans un filtre de mode commun.

Un autre objet d'un mode de réalisation de la présente invention est de proposer une structure intégrée compatible avec une protection ESD.

Un autre objet d'un mode de réalisation de la présente invention est de proposer une solution aisément intégrable.

Pour atteindre tout ou partie de ces objets ainsi que d'autres, il est prévu un filtre de mode commun comportant :
en série entre une première borne d'entrée et une première borne de sortie, un premier et un deuxième éléments inductifs couplés positivement ;
en série entre une seconde borne d'entrée et une seconde borne de sortie, un troisième et un quatrième éléments inductifs couplés positivement ; et
en série entre chaque point milieu desdites associations en série d'éléments inductifs et la masse, un élément capacitif et un cinquième élément inductif.

Selon un mode de réalisation de la présente invention, le cinquième élément inductif est commun aux deux éléments capacitifs.

Selon un mode de réalisation de la présente invention, un élément capacitif additionnel est connecté en parallèle sur le cinquième élément inductif.

Selon un mode de réalisation de la présente invention, les points de phase respectifs des premier, deuxième, troisième et quatrième éléments inductifs sont tous dirigés soit vers les bornes d'entrée, soit vers les bornes de sortie.

Selon un mode de réalisation de la présente invention, lesdits éléments capacitifs sont formés par des diodes.

Selon un mode de réalisation de la présente invention, les anodes des diodes sont communes.

Selon un mode de réalisation de la présente invention, une diode additionnelle est en série avec le cinquième élément inductif entre les anodes communes desdites diodes et la masse.

Selon un mode de réalisation de la présente invention, deux diodes sont connectées en anti-série entre chaque dit point-milieu et ledit cinquième élément inductif.

Selon un mode de réalisation de la présente invention, le filtre est réalisé sous forme intégrée.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, décrite précédemment, représente un exemple de circuit électronique du type auquel s'applique à titre d'exemple la présente invention ;
la figure 2, décrite précédemment, représente un exemple usuel de filtre de mode commun ;
la figure 3 représente un mode de réalisation d'un filtre de mode commun ;
les figures 4A, 4B et 4C illustrent la réponse en fréquence du filtre de la figure 3 ;
la figure 5 représente une variante du mode de réalisation de la figure 3 ;
la figure 6 illustre des exemples de réponse du filtre de la figure 5 ;
la figure 7 représente un autre mode de réalisation d'un filtre de mode commun, protégé contre d'éventuelles décharges électrostatiques ;
la figure 8 est une coupe schématique et partielle illustrant une réalisation intégrée du filtre de mode commun décrit ;
la figure 9 est une vue de dessus de la réalisation de la figure 8 ;
la figure 10 représente un autre mode de réalisation d'un filtre de mode commun, protégé contre d'éventuelles décharges électrostatiques ; et
la figure 11 représente encore un autre mode de réalisation de filtre de mode commun protégé contre d'éventuelles décharges électrostatiques.

### Description détaillée

De mêmes éléments ont été désignés par de mêmes références aux différentes figures. Par souci de clarté, seuls les éléments utiles à la compréhension de l'invention ont été représentés et seront décrits. En particulier, les circuits connectés en amont ou en aval d'un filtre de mode commun n'ont pas été détaillés, l'invention étant compatible avec les applications usuelles de tels filtres de mode commun.

Un domaine auquel s'applique plus particulièrement la présente invention est l'utilisation de filtres de mode commun dans des systèmes de transmission radiofréquence. En particulier, des filtres de mode commun sont largement utilisés dans des équipements mobiles de communication de type téléphone portable et ce pour plusieurs raisons.

Une première raison est que les lignes différentielles véhiculant des données sont à haut débit et sont donc susceptibles de rayonner des signaux dans les différentes bandes de réception du dispositif de communication. Un filtre de mode commun sert alors à filtrer les bandes de réception du téléphone en étant placé généralement en sortie de l'émetteur différentiel générant des signaux à haut débit.

Une autre raison est que l'antenne du téléphone est généralement d'une puissance (par exemple de l'ordre de 2 watts pour des téléphones GSM) suffisante pour que son rayonnement soit capté par les lignes véhiculant les signaux à haut débit dans les circuits électroniques. Pour éviter cela, un filtre de mode commun est placé à l'entrée du récepteur différentiel et filtre les bandes de fréquence d'émission radiofréquence du téléphone.

Un autre intérêt d'un filtre de mode commun est d'éviter des rayonnements en cas de déphasage (intrinsèque ou accidentel) des signaux différentiels.

De tels déphasages peuvent provenir de légères différences de tracé des lignes conductrices sur des circuits intégrés ou imprimés. Sans filtre, la sensibilité et la réception du téléphone sont dégradées.

Pour intégrer ou réduire le coût d'un filtre de mode commun, on pourrait penser supprimer le matériau magnétique de l'exemple de la figure 2, et réaliser les inductances sous la forme d'enroulements plans dans deux niveaux conducteurs superposés (séparés par un isolant) avec une résistance série des inductances la plus faible possible (de préférence quelques ohms au maximum voire inférieur à l'ohm) afin de ne pas nuire à la transmission des signaux différentiels. Cependant, les valeurs d'inductances qu'il faudrait prévoir pour atténuer correctement le mode commun ainsi que le besoin d'une faible résistance série engendreraient un encombrement incompatible avec les souhaits de miniaturisation des circuits et dispositifs électroniques, et non compétitif avec les filtres de mode commun à matériau magnétique. Par exemple, pour réaliser un filtre présentant une atténuation de mode commun supérieure à 15 dB à 900 MHz (bande GSM), plusieurs mm² seraient nécessaires à l'intégration d'inductances de 50 nH ayant une résistance série de 2 Ω.

En outre, la surface de la structure engendrerait des capacités parasites importantes qui affecteraient à la baisse les performances en filtrage différentiel et de mode commun, et conduiraient aussi à une modification de l'impédance du filtre en mode différentiel, ce qui est critique pour des liaisons véhiculant des signaux numériques qui sont généralement adaptées en impédance.

La figure 3 représente un mode de réalisation d'un filtre 2 de mode commun.

Selon ce mode de réalisation, des bornes 22 et 24 d'entrée sont reliées à des bornes de sortie respectives 26 et 28 par l'intermédiaire d'associations en série d'éléments inductifs L42 et L46, respectivement L44 et L48. Les points milieu 21 et 23 des associations en série de ces éléments inductifs sont reliés par deux éléments capacitifs C41 et C43 en série, et le point milieu 25 de cette association en série est relié à la masse par un élément inductif L49. Les éléments inductifs L42 et L46 sont couplés positivement (coefficient de couplage k>0) et les éléments L44 et L48 sont également couplés positivement. Le couplage entre les éléments inductifs L42 et L43, respectivement L44 et L48 est illustré par des flèches référencée k. Les points de phase des enroulements L42, L44, L46 et L48 sont tous du même côté (par exemple, côté bornes d'entrée).

On notera que le filtre est bidirectionnel, c'est-à-dire que la désignation des entrées et des sorties est liée au montage du filtre dans son application.

Le fonctionnement est le suivant. Lorsque des signaux en opposition de phase sont présentés sur les bornes 22 et 24, le potentiel du point milieu 25 est nul et aucun courant ne circule dans l'inductance L49 connectée à la masse. Les signaux de mode différentiel transitent donc directement des bornes 22 à 26 ou 24 à 28 en ne subissant que l'atténuation liée à l'impédance série des éléments inductifs L42 et L46, respectivement L44 et L48.

En présence, sur les bornes 22 et 24, de signaux en phase ou d'une composante de mode commun issue d'une perturbation intervenant sur les signaux différentiels, et grâce aux éléments capacitifs 41 et 43, cette composante de mode commun est transmise au noeud 25 puis évacuée à la masse à travers l'inductance L49. Ainsi, fonctionnellement, au lieu de présenter une impédance série élevée entre les bornes d'entrée/sortie, le filtre 2 évacue les perturbations ou composantes de mode commun vers la masse, tout en laissant passer, sans pertes vers la masse, les signaux différentiels.

La structure proposée permet d'utiliser des inductances L42, L46 et L44, L48 de valeurs suffisamment faibles pour que la résistance série en mode différentiel soit acceptable, et de surface compatible avec la réalisation dans une technologie intégrée, notamment grâce au couplage entre les inductances qui permet d'augmenter d'un facteur 3 à 4 la valeur de l'inductance par rapport à une inductance de même surface mais non couplée.

Grâce au couplage entre les inductances, une partie du signal va, en mode différentiel, directement sur la sortie. Cela réduit encore l'atténuation du signal de mode différentiel et permet une bande passante plus large.

Les valeurs respectives des éléments capacitifs C41 et C43 sont de préférence égales afin d'éviter toute dissymétrie du montage et l'introduction de distorsion sur les signaux différentiels. Par ailleurs, pour respecter la symétrie des signaux différentiels, les inductances L42 et L44 sont de mêmes valeurs et les inductances L46 et L48 sont de mêmes valeurs. De préférence, ces quatre inductances sont de mêmes valeurs.

Le filtre de la figure 3 se comporte, pour les signaux de mode commun, comme un filtre passe-bas, dont la fréquence de coupure est fixée par les valeurs des différents éléments inductifs et capacitifs du circuit. Cette fréquence de coupure sera choisie pour correspondre à la bande de fréquence la plus basse des signaux de mode commun à filtrer présents dans le dispositif comportant le filtre de mode commun.

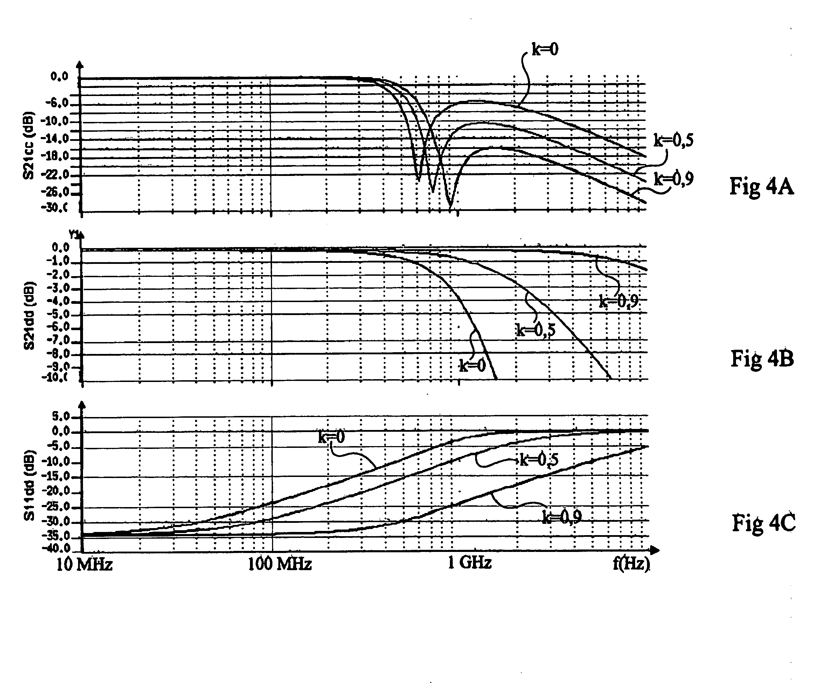

Les figures 4A, 4B et 4C illustrent trois exemples de réponse en fréquence du filtre de la figure 3 pour trois coefficients de couplage différents. Les représentations des figures 4A, 4B et 4C sont, en fréquence, en échelle logarithmique. La figure 4A représente l'atténuation de mode commun (paramètre S21cc). La figure 4B représente l'atténuation de mode différentiel (S21dd). La figure 4C illustre les pertes en réflexion (S11dd) que l'on cherche les plus faibles possible dans la bande de fonctionnement du filtre.

Les représentations des figures 4A à 4C illustrent en traits pleins un exemple de réponse avec un couplage de 0,9 et en pointillés la réponse du même filtre avec un couplage de 0,5 et en traits mixtes la réponse de ce filtre avec un couplage nul (k=0).

L'atténuation obtenue aux alentours du GHz est de l'ordre de -30 dB (figure 4B) avec un coefficient de couplage de 0,9. On voit que l'augmentation du coefficient de couplage décale légèrement la fréquence de coupure vers les fréquences élevées mais surtout améliore la réponse en mode différentiel en réduisant l'atténuation correspondante (figure 4A) et augmente l'atténuation des pertes en réflexion (figure 4C). On remarque également en figure 4B qu'une diminution de l'atténuation qui suit la fréquence de coupure disparaît rapidement quand la fréquence augmente. La pente de décroissance est ensuite de -6 dB par octave.

A titre d'exemple particulier de réalisation, un filtre tel qu'illustré en figure 3 et dont la réponse est illustrée par les figures 4A, 4B et 4C a été réalisé avec des éléments capacitifs C41 et C43 d'environ 8 picofarads, des éléments inductifs L42, L44, L46 et L48 d'environ 5 nanohenrys (présentant une résistance série d'environ 1 ohm), un coefficient de couplage d'environ 0,9 entre les éléments L42 et L46 et entre les éléments L44 et L48, et un élément inductif L49 d'environ 4 nanohenrys (présentant une résistance série d'environ 1 ohm).

Le fait de ne filtrer le cas échéant qu'une bande étroite en mode commun n'est pas très gênant dans la mesure où les perturbations susceptibles d'interférer avec les signaux de mode différentiel sont dans la bande de fréquences du fonctionnement du téléphone portable, supposée dans l'exemple particulier de mode de réalisation, la bande GSM.

Plus généralement, on tire profit du fait que la bande de fréquences de fonctionnement du dispositif électronique est généralement identifiée. Or, c'est dans cette bande que l'on souhaite éviter les perturbations de mode commun. On peut alors négliger les éventuelles perturbations hors de la bande de fonctionnement du dispositif électronique car elles n'interfèreront pas avec les signaux utiles.

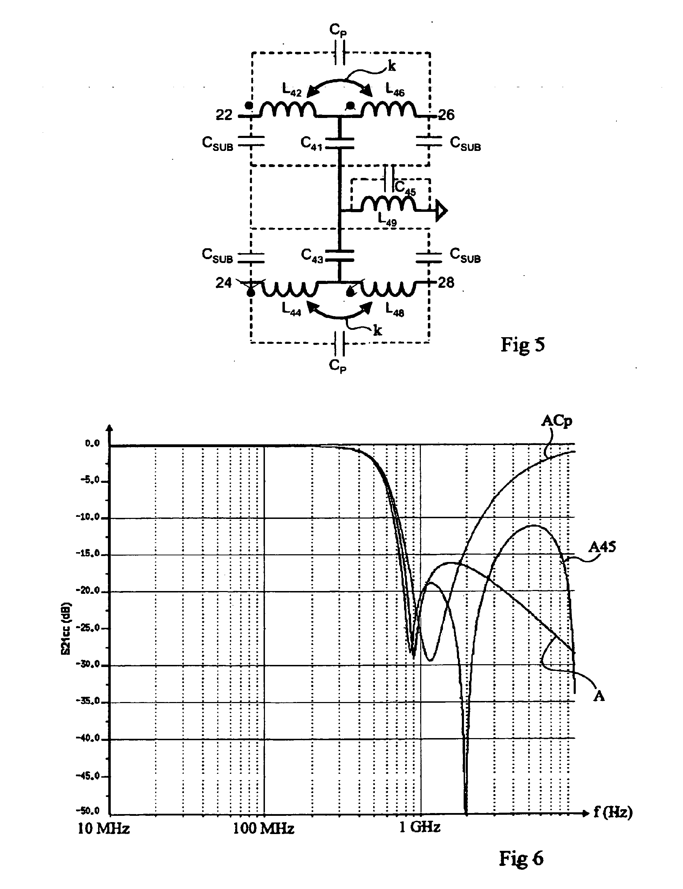

La figure 5 reprend le schéma de la figure 3 et représente les capacités parasites intervenant dans une réalisation intégrée sur un substrat. Les liaisons électriques équivalentes de ces capacités parasites sont illustrées en pointillés. En pratique, toute inductance comporte des capacités parasites, que ce soient des capacités inter-spires (Cp) ou des capacités d'oxyde au substrat (Csub), créant un chemin capacitif entre les deux noeuds de l'inductance. Ce chemin capacitif a tendance à laisser passer les signaux de mode commun et donc à dégrader l'atténuation de mode commun.

Afin de pallier à ce problème, un élément capacitif C45 additionnel représenté en pointillés peut être placé en parallèle avec l'inductance L49. Un tel élément capacitif permet d'ajouter une réjection dans la bande de fréquences du filtre et de compenser la dégradation liée aux capacités parasites des inductances.

La figure 6 représente trois exemples de réponses d'un filtre de mode commun respectivement idéal A (sans capacité parasite), avec des capacités parasites Cp de 300 femtofarads aux bornes des inductances et connectée entre chaque entrée/sortie et des capacités Csub d'environ 0,4 picofarad (courbe ACp), et avec un élément C45 d'environ 1 picofarad (courbe A45). La courbe A45 montre l'amélioration apportée par la capacité C45 sur l'atténuation de mode commun, en compensant la dégradation due aux capacités parasites Cp et Csub.

Le couplage entre les inductances L42 et L46, et entre les inductances L44 et L48, permet en outre d'utiliser pour les capacités C41 et C43 des valeurs de plusieurs picofarads sans pour autant dégrader de façon significative la fréquence de coupure en mode différentiel (ce qui serait le cas si les capacités étaient connectées sur les entrées ou les sorties), permettant l'intégration des capacités sous la forme de diodes de protection contre les décharges électrostatiques.

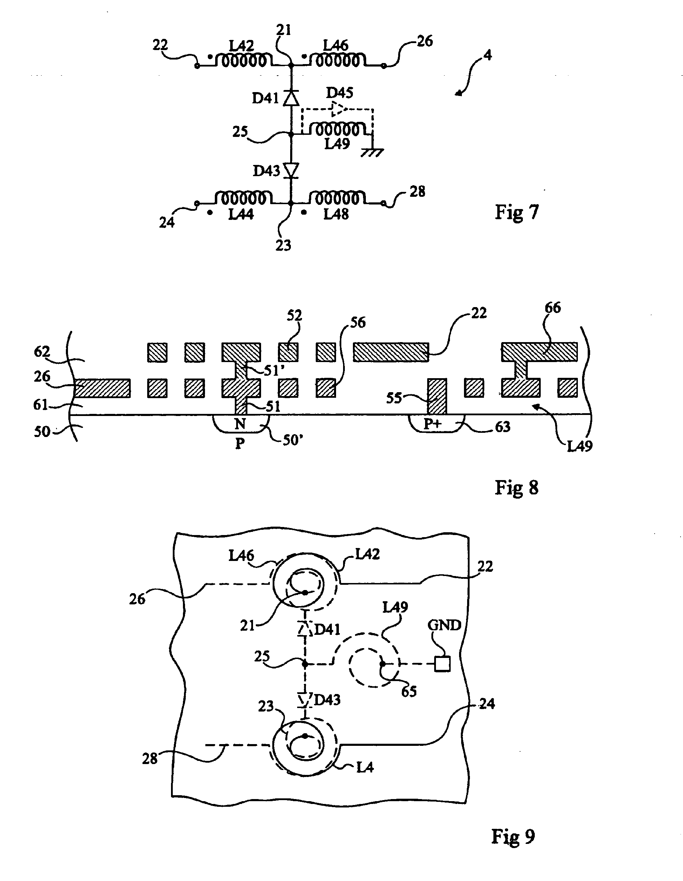

La figure 7 représente un mode de réalisation d'un filtre de mode commun basé sur la structure du filtre de la figure 3 et associé à des éléments de protection contre des décharges électrostatiques (ESD). L'obtention de la protection ESD vient du remplacement des éléments capacitifs C41, C43 par des diodes D41, D43 dont les anodes respectives sont côté noeud 25. Le cas échéant, l'élément capacitif C45 de la figure 5 peut être remplacé par une diode D45 dont l'anode serait connectée aux anodes des diodes D41 et D43.

La figure 8 est une coupe partielle illustrant un exemple de réalisation sous forme intégrée du filtre décrit précédemment.

La figure 9 est une vue de dessus du filtre de la figure 8.

Dans ce mode de réalisation, on suppose l'intégration des diodes D41, D43 et D45 dans un substrat semiconducteur 50 par exemple de type P. La réalisation d'une diode PN (région 50' dopée N) dans un tel substrat ne pose pas de difficulté. Un premier enroulement inductif (par exemple L46) est réalisé dans un niveau conducteur 56 et son extrémité interne (noeud 21) est reliée par un via conducteur 51 à la cathode (région 50') de la diode D41. Le premier niveau conducteur 56 est séparé du substrat 50 par un niveau isolant 61. Un deuxième niveau conducteur 52 est rapporté sur la structure avec interposition d'un deuxième niveau isolant 62. L'enroulement L42 est réalisé dans ce niveau 52 et son extrémité interne est reliée, par un via 51', au centre de l'enroulement L46 et au via 51. Comme l'illustre la figure 7, pour respecter les positions respectives des points de phase, les enroulements tournent dans le même sens depuis la borne 22 jusqu'à la borne 26. La même structure empilée est reproduite pour les éléments inductifs L44 et L48. L'enroulement constitutif de l'inductance L49 est réalisé, par exemple, dans le premier niveau conducteur 56. Le centre de l'enroulement L49 est relié par un via 65 à une piste 66 de connexion à la masse GND. L'extrémité externe de l'enroulement 25 est reliée aux anodes respectives des diodes D41 et D43, par exemple, par une région 63 dopée P+ ou par contact direct avec le substrat P.

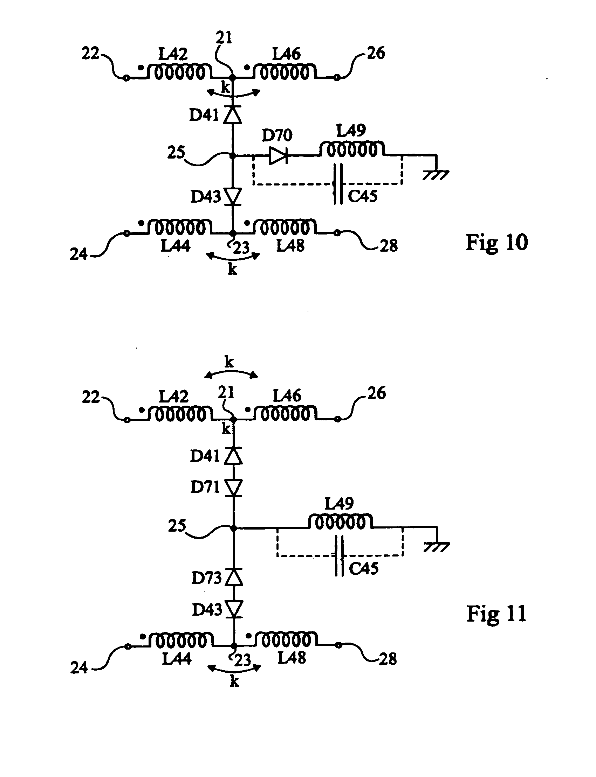

La figure 10 représente un mode de réalisation d'un filtre de mode commun adapté à une protection bidirectionnelle contre des décharges électrostatiques.

Par rapport aux structures précédentes, une diode D70 est connectée en série avec l'inductance L49 entre le point 25 et la masse, l'anode de cette diode étant côté point 25. La diode D70 peut être connectée côté point 25 ou côté masse. Un avantage d'une connexion directe de l'anode de la diode au point 25 est que cela facilite une réalisation intégrée. Par rapport au mode de réalisation de la figure 8, il suffit d'ajouter une région dopée N+ au niveau du contact de substrat (à la place de la région 63). Comme dans les modes de réalisation précédents, une capacité C45 optionnelle (en pointillés) ou une diode D45 peut être connectée entre le noeud 25 et la masse.

Fonctionnellement, la différence est que les décharges électrostatiques sont évacuées quelle que soit leur polarité.

De préférence, la surface de la diode D70 est supérieure à celles des diodes D41 et D43 (capacité équivalente de la diode D70 supérieure à celles des diodes D41 et D43).

La figure 11 représente un autre mode de réalisation d'un filtre de mode commun adapté à une protection bidirectionnelle contre des décharges électrostatiques.

Par rapport au mode de réalisation de la figure 10, la diode D70 est remplacée par deux diodes D71 et D73 intercalées entre les diodes respectives D41 et D43 et le point 25. La diode D71 est connectée en anti-série avec la diode D41, c'est-à-dire que leurs anodes sont interconnectées (en variante, les positions des diodes D41 et D71 sont inversées et sont reliées l'une à l'autre par leurs cathodes. La diode D73 est connectée en anti-série avec la diode D43.

Les structures décrites permettent de réaliser un filtre de mode commun sans recourir à des matériaux magnétiques tout en restant dans des valeurs d'inductances raisonnables d'un point de vue d'intégration. De plus, les valeurs des éléments capacitifs rendent la structure compatible avec la réalisation de diodes PN pour remplir des fonctions de protection contre des décharges électrostatiques.

Différents modes de réalisation avec diverses variantes ont été décrits. Diverses variantes et modifications apparaîtront à l'homme de l'art. On notera que l'homme de l'art pourra combiner divers éléments de ces divers modes de réalisation et variantes sans faire preuve d'activité inventive. En particulier, les valeurs à donner aux différents composants dépendent de l'application et des bandes de coupure souhaitées pour le mode commun.

Par ailleurs, on pourra chercher à minimiser les capacités parasites, par exemple, en superposant au minimum les pistes, en utilisant des techniques dites "d'écran" (shielding), en choisissant des formes particulières (carrées, rondes, etc.).

De plus, la réalisation pratique de l'invention sous forme de circuit intégré est à la portée de l'homme du métier à partir des indications fonctionnelles données ci-dessus et des contraintes que lui impose la technologie utilisée, et d'autres réalisations pratiques que celles exposées ci-dessus à titre d'exemple peuvent être envisagées pourvu de respecter les fonctionnalités décrites.

En outre, bien que les modes de réalisation décrits s'appliquent particulièrement à une réalisation intégrée, ils peuvent également être réalisés sur circuit imprimé.

## Revendications

1. Filtre (2 ; 4) de mode commun comportant :
en série entre une première borne d'entrée (22) et une première borne de sortie (26), un premier (L42) et un deuxième (L46) éléments inductifs couplés positivement ;
en série entre une seconde borne d'entrée (24) et une seconde borne de sortie (28), un troisième (L44) et un quatrième (L48) éléments inductifs couplés positivement ;
le filtre étant **caractérisé par**, en série entre chaque point milieu (21, 23) desdites associations en série d'éléments inductifs et la masse, un élément capacitif (C41, C43 ; D41, D43) et un cinquième élément inductif (L49) commun aux deux éléments capacitifs.

2. Filtre selon la revendication 1, dans lequel un élément capacitif additionnel (C45, D45) est connecté en parallèle sur le cinquième élément inductif (L49).

3. Filtre selon l'une quelconque des revendications 1 ou 2, dans lequel les points de phase respectifs des premier (L42), deuxième (L46), troisième (L44) et quatrième (L48) éléments inductifs sont tous dirigés soit vers les bornes d'entrée (22, 24), soit vers les bornes de sortie (26, 28).

4. Filtre selon l'une quelconque des revendications 1 à 3, dans lequel lesdits éléments capacitifs sont formés par des diodes (D41, D43, D45).

5. Filtre selon la revendication 4, dans lequel les anodes des diodes (D41, D43, D45) sont communes.

6. Filtre selon la revendication 5, dans lequel une diode additionnelle (D70) est en série avec le cinquième élément inductif (L49) entre les anodes communes desdites diodes et la masse.

7. Filtre selon la revendication 4, dans lequel deux diodes sont connectées en anti-série entre chaque dit point-milieu (21, 23) et ledit cinquième élément inductif.

8. Filtre selon l'une quelconque des revendications 1 à 7, réalisé sous forme intégrée.

## Claims

1. A common-mode filter (2; 4) comprising:
in series between a first input terminal (22) and a first output terminal (26), a first (L42) and a second (L46) positively coupled inductive elements;
in series between a second input terminal (24) and a second output terminal (28), a third (L44) and a fourth (L48) positively coupled inductive elements;
the filter being **characterized by** in series between each midpoint (21, 23) of said series associations of inductive elements and the ground, a capacitive element (C41, C43; D41, D43) and a fifth inductive element (L49) common to the two capacitive elements.

2. The filter of claim 1, wherein an additional capacitive element (C45, D45) is connected in parallel on the fifth inductive element (L49).

3. The filter of claim 1 or 2, wherein the respective phase points of the first (L42), second (L46), third (L44), and fourth (L48) inductive elements are all directed either towards the input terminals (22, 24), or towards the output terminals (26, 28).

4. The filter of any of claims 1 to 3, wherein said capacitive elements are formed by diodes (D41, D43, D45).

5. The filter of claim 4, wherein the anodes of said diodes (D41, D43, D45) are common.

6. The filter of claim 5, wherein an additional diode (D70) is coupled in series with the fifth inductive element (L49) between the common anodes of said diodes and ground.

7. The filter of claim 4, wherein two diodes are connected in anti-series between each said mid-point (21, 23) and said fifth inductive element.

8. The filter of any of claims 1 to 7, made in integrated form.

## Patentansprüche

1. Ein Gemeinschaftsmodusfilter (2; 4), der folgendes aufweist:
in Serie zwischen einem ersten Eingangsanschluss (22) und einem ersten Ausgangsanschluss (26), ein erstes (L42) und ein zweites (L46) positiv gekoppeltes induktives Element;
in Serie zwischen einem zweiten Eingangsanschluss (24) und einem zweiten Ausgangsanschluss (28), ein drittes (L44) und ein viertes (L48) positiv gekoppeltes induktives Element;
wobei der Filter **dadurch gekennzeichnet ist, dass** er in Serie zwischen jedem Mittelpunkt (21, 23) der Serien von assoziierten induktiven Elementen und Erde ein kapazitives Element (C41, C43; D41, D43) aufweist, und ein fünftes induktives Element (L49) gemeinsam mit den zwei kapazitiven Elementen.

2. Filter nach Anspruch 1, wobei ein zusätzliches kapazitives Element (C45, D45) parallel zu dem fünften induktiven Element (L49) verbunden ist.

3. Filter nach Anspruch 1 oder 2, wobei die jeweiligen Phasenpunkte des ersten (L42), des zweiten (L46), des dritten (L44) und des vierten (L48) induktiven Elements alle entweder zu den Eingangsanschlüssen (22, 24) oder zu den Ausgangsanschlüssen (26, 28) gerichtet sind.

4. Filter nach einem der Ansprüche 1 bis 3, wobei die kapazitiven Elemente durch Dioden (D41, D43, D45) ausgebildet sind.

5. Filter nach Anspruch 4, wobei die Anoden der Dioden (D41, D43, D45) gemeinsam sind.

6. Filter nach Anspruch 5, wobei eine zusätzliche Diode (D70) in Serie mit dem fünften induktiven Element (L49) zwischen den Gemeinschaftsanoden der Dioden und Erde gekoppelt ist.

7. Filter nach Anspruch 4, wobei zwei Dioden in entgegengesetzter Serie zwischen jedem der Mittelpunkte (21, 23) und dem fünften induktiven Element verbunden sind.

8. Filter nach einem der Ansprüche 1 bis 7, der in integrierter Form ausgebildet ist.
